# EUROPEAN PATENT APPLICATION

(11) **EP 3 748 165 A1**
(43) Date of publication of application: **09.12.2020**
(21) Application number: 20157126.2
(22) Date of filing: 13.02.2020
(51) Int. Cl.: F04C 18/02, F04C 23/00, H01R 13/52

(54) **MOTOR-OPERATED COMPRESSOR**

(30) Priority: 07.06.2019 KR 20190067409
(71) Applicant: LG Electronics Inc., 07336 SEOUL (KR)
(72) Inventor: KIM, Joohyung, 08592 Seoul (KR); KIM, Bumsuk, 08592 Seoul (KR); CHOI, Yicheol, 08592 Seoul (KR); PARK, Ilyoung, 08592 Seoul (KR)
(74) Representative: Vossius & Partner Patentanwälte Rechtsanwälte mbB

(57) **Abstract**

Motor-operated compressor (1000) comprising:
a compression module (1100) configured to compress a fluid to be compressed by an orbiting motion of a scroll (1142);
an inverter module (1200) configured to control an operation of the compression module (1100);
a driving motor (1130) provided in the compression module (1100) and configured to provide a rotational force for the orbiting motion of the scroll (1142);
a power element (1270) provided in the inverter module (1200) and configured to provide power to the driving motor (1130); and
a three-phase airtight terminal (1260) electrically connecting the power element (1270) and the driving motor (1130) and having columnar conductors (1261a, 1261b, 1261c) and columnar insulators (1262a, 1262b, 1262c) disposed in an alternating manner along concentric circles.

## Description

### BACKGROUND

### 1. Technical Field

The present disclosure relates to a motor-operated compressor operated by a motor.

### 2. Description of the Related Art

Compressors are classified into a mechanical type using an engine as an operating source and a motor-operated type using a motor as an operating source.

For a motor-operated compressor, a scroll compression method suitable for a high compression ratio operation is widely known. A motor part is installed inside a sealed casing of the motor-operated compressor having a scroll compression method (hereinafter, abbreviated to motor-operated compressor). And a compression part including a fixed scroll and an orbiting scroll is installed on one side of the motor part. The motor part and the compression part are connected to a rotational shaft. A rotational force of the motor part is transmitted to the compression part through the rotational shaft. The compression part compresses a fluid such as a refrigerant by the rotational force transmitted through the rotational shaft.

A three-phase connector for inverter output is disclosed in Korean Patent Laid-Open Publication No. 10-2013-0025234 (published on March 11, 2013). The three-phase connector electrically connects an inverter and a driving unit to transfer an output of the inverter to the driving unit. The three-phase connector for the output of the inverter disclosed in the patent document has a structure in which connecting portions allowing three phases to be connected one by one are disposed to be spaced apart from each other and in parallel.

In the motor-operated compressor, the structure of electrically connecting the inverter and the driving unit occupies a large part of the inverter volume and is an important factor related to reliability, vibration, and the like. However, the structure of the three-phase connector for the output of the inverter disclosed in the patent document has a limitation in miniaturization of the inverter.

In addition, the three-phase connector for the output of the inverter disclosed in the patent document provides three vibration transmission paths to transmit vibration generated in the driving unit to the inverter. Accordingly, the structure of the three-phase connector for inverter output disclosed in the patent document has a limitation in reducing vibration transmitted from the driving unit to the inverter.

Lastly, a complicated structure of the three-phase connector increases weight and fabricating cost of the entire compressor, and therefore, an introduction of a structure that lowers the cost is needed.

### SUMMARY

One aspect of the present disclosure is to propose a structure that reduces a volume occupied by a three-phase airtight terminal in a volume of an inverter by simplifying a shape of the three-phase airtight terminal for electrical connection between the inverter and a driving unit, through which a dead volume of an inverter module and a volume of an entire compressor can be reduced as compared with the related art.

Another aspect of the present disclosure is to reduce vibration transmitted from the driving unit to the inverter by simplifying the vibration transmission path of the three-phase airtight terminal.

Another aspect of the present disclosure is to provide a simplified structure to reduce weight and fabricating cost of the three-phase airtight terminal.

Another aspect of the present disclosure is to provide a structure that can improve assembly property, insulation performance, and durability of the three-phase airtight terminal.

A motor-operated compressor of the present disclosure includes a three-phase airtight terminal to electrically connect a power element and a driving motor. The three-phase airtight terminal has columnar conductors and columnar insulators disposed in an alternating manner along concentric circles.

The driving motor is provided in a compression module.

The compression module is configured to compress a fluid to be compressed by an orbiting motion of a scroll.

The driving motor is configured to provide a rotational force for the orbiting motion of the scroll.

The power element is provided in the inverter module.

The inverter module is configured to control an operation of the compression module.

The power element is configured to provide power to the driving motor.

The three-phase airtight terminal includes a first conductor in a cylindrical shape disposed in a center of the concentric circle, a first insulator in a hollow cylindrical shape formed to surround the first conductor, a second conductor in a hollow cylindrical shape formed to surround the first insulator, a second insulator in a hollow cylindrical shape formed to surround the second conductor, a third conductor in a hollow cylindrical shape formed to surround the second insulator, and a third insulator in a hollow cylindrical shape formed to surround the third conductor.

A length of the second conductor in a height direction of the cylindrical shape is shorter than the first conductor and longer than the third conductor.

A length of the first insulator is shorter than the first conductor and longer than the second conductor in the height direction of the cylindrical shape, a length of the second insulator is shorter than the second conductor and longer than the third conductor in the height direction of the cylindrical shape, and a length of the third insulator is shorter than the third conductor in the height direction of the cylindrical shape.

Both ends of the first conductor protrude more than the first insulator based on the height direction of the cylindrical shape, both ends of the second conductor are exposed between the first insulator and the second insulator based on the height direction of the cylindrical shape, and both ends of the third conductor are exposed between the second insulator and the third insulator based on the height direction of the cylindrical shape.

The motor-operated compressor further includes a busbar electrically connecting the conductor of the three-phase airtight terminal and the power element, and a connecting clip electrically connecting the conductor of the three-phase airtight terminal and the driving motor, wherein the busbar and the connecting clip are configured to surround an outer circumferential surface of the conductor, respectively.

The busbar and the connecting clip are press-fitted to the outer circumferential surface of the conductor, respectively.

The inverter module includes an inverter housing or an inverter cover forming a boundary between the compression module and the inverter module, wherein the three-phase airtight terminal penetrates through the inverter housing or the inverter cover, and is physically coupled to the inverter housing or the inverter cover.

The insulator disposed at outermost of the insulators includes an inverter coupling portion protruding in an annular shape in a radial direction, wherein the inverter coupling portion is in close contact with one surface of the inverter housing or one surface of the inverter cover.

The motor-operated compressor further includes a sealing member in an annular shape, wherein the sealing member is disposed between the inverter coupling portion and one surface of the inverter housing or between the inverter coupling portion and one surface of the inverter cover.

The motor-operated compressor further includes an airtight terminal housing formed to surround the three-phase airtight terminal, wherein the airtight terminal housing includes a first housing provided in the inverter module and coupled to one side of the three-phase airtight terminal based on the height direction of the cylindrical shape, and a second housing provided in the compression module and coupled to another side of the three three-phase airtight terminal based on the height direction of the cylindrical shape.

The inverter module includes the inverter housing or the inverter cover forming a boundary between the compression module and the inverter module, wherein the first housing includes a coupling member coupling portion protruding in a radial direction from both sides, wherein the coupling member coupling portion is in close contact with the inverter housing or the inverter cover, and is fixed by a coupling member penetrated through the coupling member coupling portion and coupled to the inverter housing or the inverter cover.

The second housing is provided with a driving motor coupling portion physically coupled to the driving motor, and the driving motor coupling portion is coupled to the driving motor in a hook coupling manner.

The second housing is provided with a positioning protrusion protruding toward the driving motor, and the positioning protrusion is inserted into a positioning groove formed in the driving motor.

According to the present disclosure having the aforementioned structure, the power element and the driving motor can be electrically connected by the three-phase airtight terminal having a plurality of conductors and a plurality of insulators disposed in an alternating manner along concentric circles. The three-phase airtight terminal of the structure described above reduces a volume ratio occupied in the motor-operated compressor due to a smaller volume compared to the related art structure, which may result in providing a free space available for other uses or reducing a volume of the motor-operated compressor.

In addition, compared to the related art structure in which the three-phase airtight terminal is disposed in parallel and provides vibration transmission paths, the present disclosure provides only a single vibration transmission path by a concentric-circle structure of the three-phase airtight terminal to reduce vibration transmitted from the motor part to the inverter.

Further, the present disclosure provides not only the structural simplification of the three-phase airtight terminal, but also provides an effect of reducing weight and fabricating cost of the motor-operated compressor by the above simplification.

In addition, according to the present disclosure, unlike the related art structure in which the three-phase terminals had to be assembled three-times, the three-phase airtight terminals can be assembled by only one-time assembly, thereby improving an assembly property of the motor-operated compressor.

In addition, according to the present disclosure, unlike the related art structure in which the three-phase terminals are separated from each other to maintain mutual insulation, insulators are disposed between conductors to ensure not only physical coupling but also insulation performance between the conductors.

### BRIEF DESCRIPTION OF THE DRAWINGS

FIG. 1 is a perspective view illustrating one embodiment of a motor-operated compressor disclosed in the present disclosure.
FIG. 2 is an exploded perspective view illustrating a compression module and an inverter module separated from the motor-operated compressor of FIG. 1.
FIG. 3 is a sectional view of the motor-operated compressor of FIG. 1.
FIG. 4 is a partial perspective view illustrating one side and a periphery of a three-phase airtight terminal exposed when an inverter housing is separated from an inverter cover.
FIG. 5 is a sectional view of a three-phase airtight terminal.
FIG. 6 is a partial perspective view illustrating an internal structure and a periphery of the three-phase airtight terminal exposed when a housing of the three-phase airtight terminal of FIG. 4 is separated.
FIG. 7 is a partial perspective view illustrating another side and a periphery of the three-phase airtight terminal exposed when a main housing is separated from an inverter cover.
FIG. 8 is a partial perspective view illustrating an internal structure and a periphery of the three-phase airtight terminal exposed when a housing of the three-phase airtight terminal of FIG. 7 is separated.

### DETAILED DESCRIPTION OF THE EMBODIMENTS

Hereinafter, description will be given in more detail of a motor-operated compressor according to the present disclosure, with reference to the accompanying drawings.

For the sake of brief description with reference to the drawings, the same or equivalent components will be provided with the same reference numbers, and description thereof will not be repeated.

It will be understood that when an element is referred to as being "connected with" another element, the element can be connected with the another element or intervening elements may also be present. In contrast, when an element is referred to as being "directly connected with" another element, there are no intervening elements present.

A singular representation may include a plural representation unless it represents a definitely different meaning from the context.

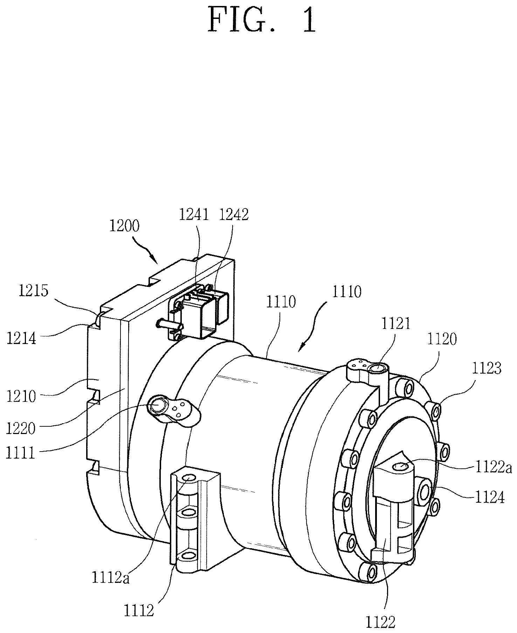

FIG. 1 is a perspective view illustrating one embodiment of the motor-operated compressor disclosed in the present disclosure.

The motor-operated compressor 1000 includes a compression module 1100 and an inverter module 1200.

The compression module 1100 refers to a collection of parts to compress a fluid such as a refrigerant. The inverter module 1200 refers to a collection of parts to control an operation of the compression module 1100. The inverter module 1200 may be coupled to one side of the compression module 1100. When a direction is set based on a flow of a fluid compressed by the motor-operated compressor 1000, one side of the compression module 1100 refers to a front side of the compression module 1100. Since a fluid to be compressed is introduced into an intake port 1111 and discharged to a discharge port 1121, the inverter module 1200 disposed close to the intake port 1111 may be described as being coupled to the front side of the compression module 1100.

An appearance of the compression module 1100 may be defined by a main housing 1110 and a rear housing 1120.

The main housing 1110 has an appearance with a shape of a hollow cylinder, a polygonal pillar, or the like. The main housing 1110 may be disposed to extend in a horizontal direction. Both ends of the main housing 1110 may be entirely or partially opened. For example, a front end of the main housing 1110 may be entirely opened, and a rear end of the main housing 1110 may be partially opened. Here, the front end of the main housing 1110 refers to an end coupled to the inverter module 1200. The rear end of the main housing 1110 refers to an end coupled to the rear housing 1120.

An inner diameter and an outer diameter of the main housing 1110 may not be constant. For example, as illustrated in FIG. 1, the front end and the rear end may have an outer diameter greater than a middle portion between the front end and the rear end.

The intake port 1111 and a mount part 1112 are provided on an outer circumferential surface of the main housing 1110.

The intake port 1111 forms a passage through which a fluid be compressed is supplied into an internal space of the motor-operated compressor 1000. The intake port 1111 may protrude from the outer circumferential surface of the main housing 1110. The intake port 1111 may be connected to a suction pipe (not shown) through which a fluid to be compressed is supplied to the motor-operated compressor 1000. The intake port 1111 has a shape corresponding to the suction pipe to be coupled to the suction pipe.

The mount part 1112 is a structure to fix the motor-operated compressor 1000 to an installation area. The mount part 1112 may protrude from the outer circumferential surface of the main housing 1110. The mount part 1112 may protrude along a circumferential direction of the main housing 1110. The mount part 1112 may extend along a tangential direction of the outer circumferential surface of the main housing 1110.

The mount part 1112 may include a coupling member coupling hole 1112a that can be engaged with any coupling member. The coupling member coupling hole 1112a may be open toward the tangential direction of the outer circumferential surface of the main housing 1110. Mount parts 1112 may be provided at one side and another side of the main housing 1110, respectively. For example, in FIG. 1, the mount parts 1112 are provided on the left and right sides and the top and bottom sides of the main housing 1110, respectively.

The rear housing 1120 is disposed at another side of the main housing 1110 or a rear side of the main housing 1110. The rear housing 1120 may be configured to cover the rear end of the main housing 1110.

The rear housing 1120 includes a discharge port 1121 and a mount part 1122.

The discharge port 1121 is configured to discharge the compressed fluid from the motor-operated compressor 1000 to outside. The discharge port 1121 may protrude from an outer circumferential surface of the rear housing 1120. The discharge port 1121 may be connected to a discharge pipe (not shown) to supply the compressed fluid to a downstream side device of a refrigeration cycle. The discharge port 1121 has a shape corresponding to the discharge pipe to be coupled to the discharge pipe.

The mount part 1122 is provided on a rear outer surface of the rear housing 1120. The mount part 1122 may protrude from the rear outer surface of the rear housing 1120. The mount part 1122 may extend in an up-down direction. Coupling member coupling holes 1112a are formed in the mount part 1122. The mount part 1122 serves a role substantially the same as the mount part 1112 of the main housing 1110.

The main housing 1110 and the rear housing 1120 may be coupled to each other by a plurality of coupling members 1123. The coupling members 1123 are inserted toward the main housing 1110 side from the rear housing 1120 side. A plurality of coupling members 1123 may be installed along a circumference of the rear housing 1120.

A relief valve 1124 is installed at the rear housing 1120. The relief valve 1124 is configured to open at or above a reference pressure. The relief valve 1124 is to prevent a high pressure fluid from flowing into a vehicle through the discharge port 1121 under abnormal circumstances. When an inside of the motor-operated compressor 1000 is overpressured at or above the reference pressure due to an abnormal situation such as a vehicle accident in which the vehicle is equipped with the motor-operated compressor 1000, the relief valve 1124 is opened. When the relief valve 1124 is opened, the high pressure fluid is discharged outside the motor-operated compressor 1000 through the relief valve 1124.

Next, the inverter module 1200 will be described.

The appearance of the inverter module 1200 is defined by an inverter housing 1210 and an inverter cover 1220.

The inverter housing 1210 and the inverter cover 1220 are coupled to each other to form a mounting space for circuit components and the like.

The inverter housing 1210 is disposed at a front end of the motor-operated compressor 1000. One surface of the inverter housing 1210 is disposed to face a front of the motor-operated compressor 1000, and forms one outer wall of the motor-operated compressor 1000. The inverter housing 1210 has a side wall, which protrudes toward the inverter cover 1220 along an edge of the one surface. The inverter housing 1210 may have an outer circumferential surface greater than the outer circumferential surface of the main housing 1110.

The inverter cover 1220 is coupled to the inverter housing 1210. The inverter cover 1220 may be defined in a plate shape covering an opening of the inverter housing 1210 and a front end of the main housing 1110. An edge of the inverter cover 1220 may have a shape corresponding to a side wall of the inverter housing 1210.

The inverter housing 1210 and the inverter cover 1220 are coupled to each other by a plurality of coupling members 1215. The plurality of coupling members 1215 are inserted toward the inverter cover 1220 from the inverter housing 1210. The plurality of coupling members 1215 are installed at positions spaced apart from each other along a circumference of the inverter housing 1210. As the inverter cover 1220 is coupled to the inverter housing 1210, the inverter module 1200 has an internal space.

The inverter cover 1220 has a first surface and a second surface (or a front side and a rear side). The first surface of the inverter cover 1220 is coupled with the inverter housing 1210, and the second surface is coupled with the main housing 1110.

The inverter cover 1220 is provided with a power connector 1241 and a communication connector 1242. Each of the power connector 1241 and the communication connector 1242 is configured to be connectable with respective mating connectors (not shown). The power connector 1241 is configured to transfer power supplied from the mating connector to the circuit component and the likes. The communication connector 1242 electrically transmits a control command or the like transmitted from outside to the circuit component and the likes so that the motor-operated compressor 1000 is operated according to the control command.

Hereinafter, an internal structure of the motor-operated compressor 1000 will be described.

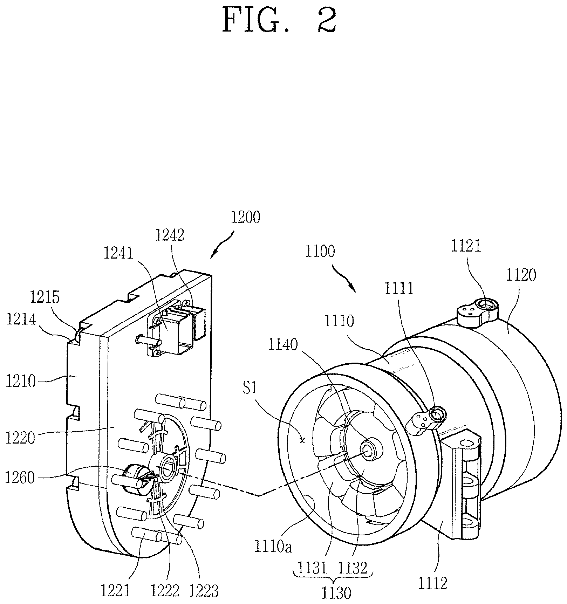

FIG. 2 is an exploded perspective view illustrating the compression module 1100 and the inverter module 1200 separated from the motor-operated compressor 1000 of FIG. 1.

When the compression module 1100 and the inverter module 1200 are separated from each other, a motor chamber S1 is exposed through the front end 1110a of the main housing 1110. The motor chamber S1 refers to a space in which the driving motor 1130 is installed.

The motor chamber S1 is formed by coupling of the main housing 1110 and the inverter cover 1220. A sealing member such as an O-ring may be installed along a coupling position of the main housing 1110 and the inverter cover 1220 to seal the motor chamber S1.

The driving motor 1130 is installed in the motor chamber S1. The driving motor 1130 includes a stator 1131 and a rotor 1132.

The stator 1131 is installed along an inner circumferential surface of the main housing 1110 and is fixed to the inner circumferential surface of the main housing 1110. The stator 1131 is inserted into and fixed to the main housing 1110 in a manner of press-fitting (hot pressing). Therefore, setting an insertion depth of the stator 1131 inserted into the main housing 1110 small (or shallow) is advantageous to ensure ease of assembling of the stator 1131. Furthermore, setting the insertion depth of the stator 1131 small is advantageous in maintaining concentricity of the stator 1131 in the press-fitting process.

The rotor 1132 is installed in an area surrounded by the stator 1131. The rotor 1132 is rotated by electromagnetic interaction with the stator 1131.

The rotational shaft 1140 is coupled to a center of the rotor 1132. The rotating shaft 1140 transmits a rotational force generated by the driving motor 1130 while being rotated together with the rotor 1132 to a compression part to be described later. The rotational shaft 1140 is inserted into and fixed to the rotor 1132 in a manner of press-fitting (hot pressing).

The inverter cover 1220 and the main housing 1110 are coupled by a plurality of coupling members 1221. The plurality of coupling members 1221 may penetrate through holes formed in the inverter cover 1220 from the first surface to the second surface direction, and protrude toward the main housing 1110. The plurality of coupling members 1221 are coupled to the front end 1110a of the main housing 1110. The plurality of coupling members 1221 are disposed at positions spaced apart from each other along a curve corresponding to an edge of the front end 1110a.

An outer surface of the inverter cover 1220 has an area surrounded by the plurality of coupling members 1221. The area surrounded by the plurality of coupling members 1221 covers a front opening of the main housing 1110.

A rotational shaft supporting portion 1222 supporting the rotational shaft 1140 of the compression module 1100 in an axial direction may be provided at a center of the area surrounded by the plurality of coupling members 1221. The rotational shaft supporting portion 1222 may protrude from a rear outer surface (second surface) of the inverter cover 1220 and may surround an end of the rotational shaft 1140.

When a fluid such as a refrigerant is compressed in the compression module 1100, the rotational shaft 1140 is forced toward the inverter module 1200 along the axial direction under influence of high pressure. When the rotational shaft supporting portion 1222 supports the rotational shaft 1140 in the axial direction, the rotational shaft 1140 may be prevented from being pushed toward the inverter module 1200.

A reinforcing rib 1223 protruding from the inverter cover 1220 may be formed around the rotational shaft supporting portion 1222 along a position corresponding to the rotational shaft supporting portion 1222. The reinforcing rib 1223 may protrude along two or more concentric circles, or may protrude along a line corresponding to a radial direction of the concentric circles.

The reinforcing rib 1223 also serves a role of increasing a contact area between the inverter cover 1220 and the fluid to be compressed. When the motor-operated compressor 1000 operates, heat is generated in the circuit components in the inverter module 1200, and thus cooling is required for smooth operation of the circuit components. The heat may be dissipated through the inverter cover 1220, and an effect of the cooling may be further increased when the reinforcing rib 1223 increases the contact area.

The three-phase airtight terminal 1260 is exposed to one side of the rotational shaft supporting portion 1222. The three-phase airtight terminal 1260 is electrically connected to the driving motor 1130 operated by three-phase power, namely, U, V, and W phases, and transmits power and electrical control commands from the inverter module 1200 to the driving motor 1130.

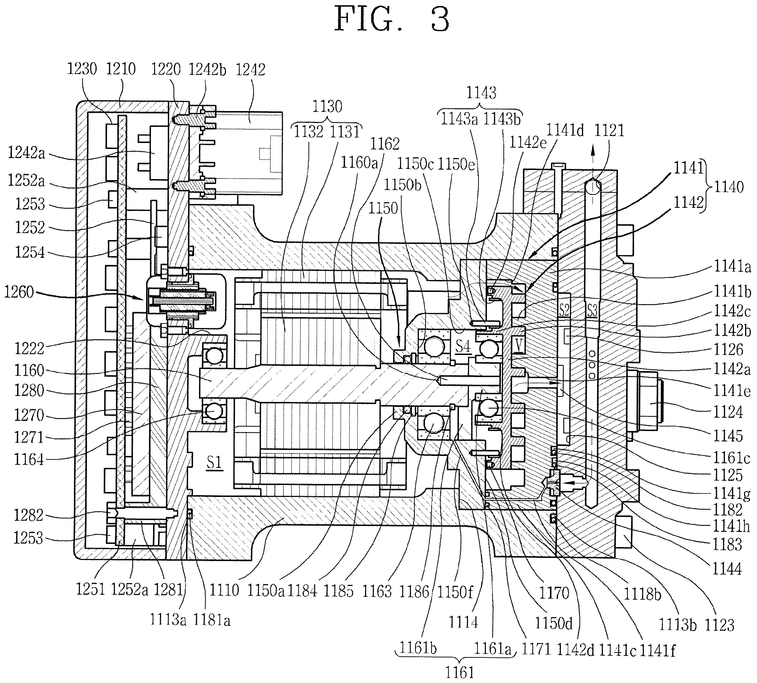

FIG. 3 is a sectional view of the motor-operated compressor of FIG. 1.

The motor-operated compressor 1000 includes the compression module 1100 and the inverter module 1200.

The compression module 1100 may include the main housing 1110, the rear housing 1120, a motor part 1130 (a driving unit or a driving motor), a compression part 1140, a main frame 1150, a rotational shaft 1160, sealing members 1170, and the like.

First, the main housing 1110 will be described.

The main housing 1110 has a shape of a hollow cylinder or a polygonal pillar. Both the front end and the rear end of the main housing 1110 are open. The front end and the rear end are based on the flow of the fluid to be compressed. For example, the front end refers to the inverter module 1200 side, and the rear end refers to the rear housing 1120 side. The front end may be referred to as a first end, and the rear end may be referred to as a second end. The inverter module 1200 is coupled to the front end of the main housing 1110, and the rear housing 1120 is coupled to the rear end of the main housing 1110.

Sealing member accommodating grooves 1113a, 1113b are formed in the main housing 1110. The sealing member accommodating grooves 1113a, 1113b may be formed along a circumference formed at each of the front end and the rear end of the main housing 1110. The sealing member accommodating grooves 1113a, 1113b are recessed in a closed curve shape toward the axial direction.

The sealing member accommodating grooves 1113a, 1113b are seated with closed curve shaped sealing members 1181a, 1181b such as an O-ring. The front side sealing member 1181a prevents a fluid to be compressed from leaking through a gap between the main housing 1110 and the inverter cover 1220. The rear side sealing member 1181b prevents the fluid to be compressed from leaking through a gap between the main housing 1110 and the rear housing 1120.

The main housing 1110 forms the motor chamber S1 together with the main frame 1150. The motor chamber S1 refers to a space in which the motor part 1130 is installed. The main housing 1110 is configured to accommodate the motor part 1130 in the motor chamber S1. The motor part 1130 is seated in the motor chamber S1 of the main housing 1110. The inverter module 1200 is coupled at the front end of the main housing 1110, and the main frame 1150 is installed at an inner side of the main housing 1110 to seal the motor chamber S1.

Next, the rear housing 1120 will be described.

The rear housing 1120 is coupled to the rear end of the main housing 1110. The rear housing 1120 covers the rear end of the main housing 1110. The rear housing 1120 is coupled to the main housing 1110 along a circumference formed at the rear end of the main housing 1110. The rear housing 1120 is disposed to face a fixed scroll 1141 of the compression part 1140.

The rear housing 1120 has a recess portion 1125 on an inner side of a circumference formed at an edge of the rear housing 1120. The recess portion 1125 is spaced apart from a fixed end plate portion 1141a. A discharge chamber S2 is formed between the rear housing 1120 and the fixed end plate portion 1141a by the recess portion 1125.

The discharge chamber S2 is configured to accommodate a refrigerant discharged from the compression part 1140. The discharge chamber S2 refers to a space where a fluid compressed at high pressure in the compression part 1140 is discharged. The discharge chamber S2 communicates with the discharge port 1121 described above with reference to FIG. 1. Therefore, the fluid compressed at high pressure is discharged to the discharge port 1121 through the discharge chamber S2 and an oil separation chamber S3 described later.

The oil separation chamber S3 is formed in the rear housing 1120. The fluid discharged to the discharge chamber S2 includes oil to lubricate moving components of the motor-operated compressor 1000 as well as a fluid to be compressed such as a refrigerant. The oil separation chamber S3 refers to a space to store oil separated from the fluid to be compressed. An arbitrary oil separator (not shown) to separate oil from the fluid to be compressed may be provided in the oil separation chamber S3. The oil separation chamber S3 is configured to store oil.

The oil separation chamber S3 communicates with the discharge chamber S2. When refrigerant and oil are discharged from the compression part 1140, the refrigerant is discharged to the discharge port 1121, and the oil is separated from the refrigerant by the oil separator (not shown) or the like and introduced into the oil separation chamber S3. The oil introduced into the oil separation chamber S3 may be stored in the oil separation chamber S3 and supplied to a back-pressure chamber S4 through an oil guiding passage to be described later and may be reused.

A bypass passage 1126 communicating with a compression chamber V and the discharge chamber S2 may be formed in the rear housing 1120. Assuming that the fixed end plate portion 1141a is in a shape of a disk, a fluid discharge passage 1141e is formed at a position close to a center of the disk, and the bypass passage 1126 communicates with the compression chamber V at a position between the fluid discharge passage 1141e and a circumference of the disk.

When the bypass passage 1126 is provided, a fluid compressed in the compression chamber V may be discharged to the discharge chamber S2, before a pressure of the fluid reaches to a desired pressure. Accordingly, the bypass passage 1126 prevents the pressure in the compression chamber V from excessively increasing beyond the desired pressure.

Next, the motor part 1130 will be described.

The motor part 1130 is configured to generate a driving force (rotational force) for an orbiting scroll 1142 to perform an orbiting motion. The motor part 1130 includes a driving motor. The driving motor is installed in the motor chamber S1. The driving motor includes the stator 1131 and the rotor 1132.

The stator 1131 is installed along the inner circumferential surface of the main housing 1110. The stator 1131 is fixed to the inner circumferential surface of the main housing 1110. The stator 1131 is inserted into and fixed to the main housing 1110 in a manner of press-fitting (hot pressing).

Setting the insertion depth (or length) of the stator 1131 inserted into the main housing 1110 small (or shallow) is advantageous to ensure ease of assembling of the stator. Furthermore, setting the insertion depth of the stator 1131 small is advantageous in maintaining concentricity of the stator 1131 in the press-fitting process of the stator 1131.

The rotor 1132 is installed in the area surrounded by the stator 1131. When power is applied to the stator 1131, the rotor 1132 is rotated by electromagnetic interaction with the stator 1131.

Next, the compression part 1140 will be described.

The compression part 1140 is configured to compress a fluid to be compressed such as a refrigerant. The compression part 1140 is provided at a rear side of the motor part 1130. The compression part 1140 includes the fixed scroll 1141 and the orbiting scroll 1142. The compression part 1140 is formed by the fixed scroll 1141 and the orbiting scroll 1142. The fixed scroll 1141 and the orbiting scroll 1142 may be referred to as a first scroll and a second scroll (or vice versa), respectively.

The fixed scroll 1141 and the orbiting scroll 1142 are disposed to face each other. The fixed scroll 1141 and the orbiting scroll 1142 are coupled to each other to form a pair of compression chambers V. As the orbiting scroll 1142 performs an orbiting motion, a volume of the compression chamber is repeatedly changed, whereby a fluid such as a refrigerant is compressed in the compression chamber V.

In the axial direction, the fixed scroll 1141 is disposed relatively far from the motor part 1130, and the orbiting scroll 1142 is disposed relatively close to the motor part 1130. The fixed scroll 1141 is disposed between the orbiting scroll 1142 and the rear housing 1120 in the axial direction. The orbiting scroll 1142 is disposed between the main frame 1150 and the fixed scroll 1141 in the axial direction.

The fixed scroll 1141 is fixed in the inner side of the main housing 1110. An outer circumferential surface of the fixed scroll 1141 is brought into contact with the inner circumferential surface of the main housing 1110. The fixed scroll 1141 is supported by the main housing 1110 in a radial direction of the rotational shaft 1160. The fixed scroll 1141 is supported by the main frame 1120 in an axial direction of the rotational shaft 1160.

A detailed structure of the fixed scroll 1141 will be described below.

The fixed scroll 1141 includes the fixed end plate portion 1141a, a fixed wrap 1141b, a side wall portion 1141c, a fluid suction passage 1141d, the fluid discharge passage 1141e, and an oil guiding passage 1141f.

The fixed end plate portion 1141a is defined in a plate shape. An outer circumferential surface of the fixed end plate portion 1141a is defined in a shape corresponding to an inner circumferential surface of the main frame 1150. For example, an outer diameter of the fixed end plate portion 1141a is substantially the same as an inner diameter of the main frame 1150. Accordingly, the fixed end plate portion 1141a may be press-fitted into the main frame 1150.

The fixed end plate portion 1141a is disposed to face an orbiting end plate portion 1142a at a position spaced apart from the orbiting end plate portion 1142a of the orbiting scroll 1142. The fixed end plate portion 1141a may be in close contact with the rear housing 1120 except for a portion corresponding to the recess portion 1125. When the fixed end plate portion 1141a is in close contact with the rear housing 1120, the discharge chamber S2 is formed by the recess portion 1125 of the rear housing 1120.

When a surface facing the orbiting scroll 1142 of both surfaces of the fixed end plate portion 1141a is referred to as a first surface, and a surface facing the rear housing 1120 is referred to as a second surface, the fixed wrap 1141b is provided on the first surface, and sealing member accommodating grooves 1141g, 1141h are formed in the second surface.

The sealing member accommodating grooves 1141g, 1141h are recessed in a closed curve shape on a first surface of the fixed end plate portion 1141a. A recessed direction of the sealing member accommodating grooves 1141g, 1141h is a direction away from the rear housing 1120. The sealing member accommodating grooves 1141g, 1141h are seated with closed curve shaped sealing members such as O-rings.

A sealing member 1182 seated in one sealing member accommodating groove 1141g of the two sealing member accommodating grooves 1141g, 1141h of the fixed end plate portion 1141a seals the discharge chamber S2. The sealing member 1182 surrounds the discharge chamber S2 in a circumferential direction of the fixed end plate portion 1141a.

A sealing member 1183 seated in another one sealing member accommodating groove 1141h of the two sealing member accommodating grooves 1141g, 1141h of the fixed end plate portion 1141a seals around a decompression member 1144. This sealing member 1183 surrounds the decompression member 1144 in the circumferential direction of the fixed end plate portion 1141a.

The one sealing member accommodating groove 1141g may be referred to as a first sealing member accommodating groove, and the another sealing member accommodating groove 1141h may be referred to as a second sealing member accommodating groove, and vice versa.

The sealing member accommodating grooves 1141g, 1141h are not necessarily formed in the fixed end plate portion 1141a. For example, the sealing member accommodating grooves 1141g, 1141h may be formed in the rear housing 1120.

The fixed wrap 1141b protrudes toward the orbiting scroll 1142 in a shape of an involute curve, an arithmetic spiral (Archimedean spiral) or an algebraic spiral (Logarithmic spiral). The involute curve refers to a curve corresponding to a trajectory of an end of a thread when the thread wound around a base circle having an arbitrary radius is pulled out without loosening. The arithmetic spiral refers to a trace of moving points when the moving points move away from a reference point at a constant speed along a straight line rotating at a constant angular velocity with respect to a fixed reference point. The algebraic spiral refers to a curve that follows a specific logarithmic function in polar coordinates. The fixed wrap 1141b may be defined in various shapes.

The fixed wrap 1141b is engaged with the orbiting wrap 1142b to form a pair of compression chambers V.

A side wall portion 1141c protrudes in a ring shape toward the orbiting scroll 1142 along an outer edge of the fixed end plate portion 1141a. The side wall portion 1141c surrounds the fixed wrap 1141b in the radial direction of the rotational shaft 1160.

An outer circumferential surface of the side wall portion 1141c is in close contact with the inner circumferential surface of the main housing 1110. Accordingly, the fixed scroll 1141 may be fixed to the inner side of the main housing 1110.

A protruding end portion of the side wall portion 1141c may be in surface contact with the main frame 1150. The main frame 1150 has a thrust surface 1150d corresponding to the orbiting scroll 1142, and an end portion of the side wall portion 1141c is in close contact with the thrust surface 1150d. As the annular side wall portion 1141c is in close contact with the thrust surface 1150d of the main frame 1150, a seating space of the orbiting scroll 1142 is formed between the fixed scroll 1141 and the main frame 1150.

An annular thrust plate (not shown) may be further installed between the side wall portion 1141c and the thrust surface 1150d in the axial direction of the rotational shaft 1160. The thrust plate may be fixed by the side wall portion 1141c and the main frame 1150.

A fluid suction passage 1141d is formed at one side of the side wall portion 1141c. The fluid suction passage 1141d is opened toward the axial direction and / or the radial direction of the rotational shaft 1160. The fluid suction passage 1141d communicates with the motor chamber S1 and the compression chamber V. Accordingly, a fluid to be compressed is introduced into the compression chamber V through the fluid suction passage 1141d in the motor chamber S1, and is compressed by the compression part 1140 in the compression chamber V.

The fluid discharge passage 1141e penetrates through the fixed end plate portion 1141a in the axial direction of the rotational shaft 1160. The fluid discharge passage 1141e communicates with the compression chamber V and the discharge chamber S2. The fluid compressed in the compression chamber V is discharged to the discharge chamber S2 through the fluid discharge passage 1141e.

A discharge valve 1145 to open and close the fluid discharge passage 1141e may be installed in the fixed end plate portion 1141a. The discharge valve 1145 is configured to be passively opened at or above a reference pressure and passively closed below the reference pressure. As a refrigerant is compressed in the compression part 1140, the discharge valve 1145 is opened when the pressure in the compression chamber V exceeds the preset pressure.

The oil guiding passage 1141f penetrates through the fixed end plate portion 1141a and the side wall portion 1141c. The oil guiding passage 1141f is configured to receive oil from the oil separation chamber S3 through the decompression member 1144 and guide the supplied oil to a back-pressure chamber S4.

Decompression member accommodating grooves (numeral not shown) are formed at positions where the rear housing 1120 and the fixed end plate portion 1141a face each other while being brought into contact to each other. One side of the decompression member 1144 is inserted into the decompression member accommodating groove formed at the rear housing 1120 side, and another side of the decompression member 1144 is inserted into the decompression member accommodating groove formed at the fixed end plate portion 1141a side. On the other hand, the decompression member 1144 may be inserted into any one groove.

The decompression member 1144 is configured to depressurize oil supplied from the oil separation chamber S3. Oil of discharge pressure stored in the oil separation chamber S3 is depressurize to an intermediate pressure by the decompression member 1144. The intermediate pressure refers to a pressure higher than a suction pressure corresponding to a pressure before the compression of the fluid and lower than the discharge pressure corresponding to a pressure after the compression of the fluid. An orifice or the like may be used as the decompression member 1144.

The sealing member 1183 may be installed around the decompression member 1144. The sealing member 1183 is defined in an annular shape like an O-ring, and is inserted into the sealing member seating groove 1141h formed in the fixed end plate portion 1141a or the rear housing 1120.

One end of the oil guiding passage 1141f formed in the fixed scroll 1141 communicates with an outlet of the decompression member 1144, and another end of the oil guiding passage 1141f communicates with the oil guiding passage 1150f of the main frame 1150. The oil supplied to the oil guiding passage 1150f of the main frame 1150 through the oil guiding passage 1141f of the fixed scroll 1141 again passes through the oil guiding passage 1150f of the main frame 1150 to be supplied to the back-pressure chamber S4. The oil supplied to the back-pressure chamber S4 lubricates an outer circumferential surface of the rotational shaft 1160 exposed to the back-pressure chamber S4, and forms back pressure in the back-pressure chamber S4.

The orbiting scroll 1142 is seated on the thrust surface 1150d of the main frame 1150. When the motor-operated compressor 1000 is provided with the thrust plate, the orbiting scroll 1142 is seated on the thrust plate. The orbiting scroll 1142 is supported by the main frame 1150 or the thrust plate in the axial direction. The orbiting scroll 1142 forms the compression chamber V together with the fixed scroll 1141. The orbiting scroll 1142 is configured to perform an orbiting motion relative to the fixed scroll 1141 to compress the fluid.

The orbiting scroll 1142 includes the orbiting end plate portion 1142a, the orbiting wrap 1142b, a driving force transmission unit 1142c, a rotation prevention mechanism seating groove 1142d, and a sealing member seating groove 1142e.

The orbiting end plate portion 1142a is defined in a plate shape corresponding to the fixed end plate portion 1141a. Since the orbiting end plate portion 1142a needs to perform an orbiting motion in an area surrounded by the main housing 1110, an outer diameter of the orbiting end plate portion 1142a is smaller than an inner diameter of the main housing 1110.

The orbiting end plate portion 1142a may have an outer diameter smaller than the side wall portion 1141c of the fixed scroll 1141. Accordingly, the orbiting end plate portion 1142a may be seated on the fixed wrap 1141b of the fixed scroll 1141. When the orbiting end plate portion 1142a is seated on the fixed wrap 1141b, the orbiting end plate portion 1142a and the fixed wrap 1141b may form a thrust surface.

When a surface facing the main frame 1150 of both surfaces of the orbiting end plate portion 1141a is referred to as a first surface, and a surface facing the fixed scroll 1141 is referred to as a second surface, the driving force transmission unit 1142c, the rotation prevention mechanism seating groove 1142d, and the sealing member seating groove 1142e are provided on the first surface, and the orbiting wrap 1142b is provided on the second surface.

Since the orbiting end plate portion 1142a is supported by the main frame 1150 in the axial direction of the rotational shaft, a thrust surface corresponding to the thrust surface 1150d of the main frame 1150 is also provided on the first surface of the orbiting end plate portion 1142a.

The annular thrust plate (not shown), which has been described above, may be installed between the orbiting end plate portion and the main frame. When the motor-operated compressor 1000 is provided with the thrust plate, the orbiting scroll 1142 is seated on the thrust plate. The orbiting scroll 1142 is supported by the main frame 1150 or the thrust plate in the axial direction.

The orbiting wrap 1142b protrudes toward the fixed scroll 1141 from the second surface of the orbiting end plate portion 1142a. Like the fixed wrap 1141b, the orbiting wrap 1142b may be defined in the shape of the involute curve, the arithmetic spiral (Archimedean spiral) or the algebraic spiral (Logarithmic spiral). The orbiting wrap 1142b may be defined in various shapes.

The orbiting wrap 1142b may be in close contact with the fixed end plate portion 1141a. Similarly, the fixed wrap 1141b may also be in close contact with the orbiting end plate portion 1142a. At least one of the axial end of the fixed wrap 1141b and the axial end of the orbiting wrap 1142b may be provided with a tip seal (not shown) to seal the compression chamber V.

The driving force transmission unit 1142c protrudes annularly toward the main frame 1150 from the first surface of the orbiting end plate portion 1142a. The driving force transmission unit 1142c may be provided at a center of the first surface. The driving force transmission unit 1142c accommodates a balance weight 1161 and a ball bearing 1161c coupled to the balance weight 1161.

A rotational force (driving force) generated in the motor part 1130 is transmitted to the driving force transmission unit 1142c through the rotational shaft 1160, the balance weight 1161, and the ball bearing 1161c. The orbiting scroll 1142 performs an orbiting motion by the rotational force transmitted through the driving force transmission unit 1142c.

The rotation prevention mechanism seating groove 1142d is formed in the first surface of the orbiting end plate portion 1142a. Assuming that the orbiting end plate portion 1142a is a disk, the driving force transmission unit 1142c is formed at a center of the circle, and the rotation prevention mechanism seating groove 1142d is formed between the center of the circle and a circumference of the circle.

The rotation prevention mechanism seating groove 1142d is recessed in a circular shape in an axial direction on the first surface of the orbiting end plate portion 1142a. The recessed direction of the rotation prevention mechanism seating groove 1142d is a direction toward the fixed scroll 1141. The rotation prevention mechanism seating groove 1142d is formed in plural. The plurality of rotation prevention mechanism seating grooves 1142d are formed at positions spaced apart from each other along a virtual circumference of the first surface. The virtual circumference is greater than a circumference of the driving force transmission unit 1142c.

The rotation prevention mechanism seating groove 1142d accommodates a rotation prevention mechanism 1143. A pin 1143a and a ring 1143b configuring the rotation prevention mechanism 1143 may be inserted into the rotation prevention mechanism seating groove 1142d.

The sealing member seating groove 1142e is formed in the first surface of the orbiting end plate portion 1142a. The sealing member seating groove 1142e is recessed in a circular shape in the axial direction on the first surface of the orbiting end plate portion 1142a. The recessed direction of the sealing member seating groove 1142e is the direction toward the fixed scroll 1141.

The sealing member seating groove 1142e may have a greater circumference than the virtual circumference described in the rotation prevention mechanism seating groove 1142d. The sealing member seating groove 1142e may be formed between an outermost edge of the orbiting end plate portion 1142a and the driving force transmission unit 1142c, and between the outermost edge of the orbiting end plate portion 1142a and the rotation prevention mechanism seating groove 1142d in the radial direction of the rotational shaft 1160.

Since the first surface of the orbiting end plate portion 1142a faces the main frame 1150, the sealing member seating groove 1142e formed in the first surface of the orbiting end plate portion 1142a also faces the main frame 1150. The sealing member seating groove 1142e is configured to accommodate an annular sealing member 1170 to seal the back-pressure chamber S4, and is defined in a closed curve shape around the back-pressure chamber S4.

The sealing member seating groove 1142e is not necessarily formed in the orbiting end plate portion 1142a. The sealing member seating groove 1142e may also be formed in the main frame 1150. A groove (not shown) on the main frame 1150 is formed in the thrust surface 1150d of the main frame 1150 and is recessed in a direction away from the orbiting scroll 1142. The groove (not shown) faces the orbiting end plate portion 1142a of the orbiting scroll 1142.

Next, the rotation prevention mechanism 1143 will be described.

The rotation prevention mechanism 1143 prevents rotation of the orbiting scroll 1142 and allows the orbiting scroll 1142 to perform an orbiting motion. Without the rotation prevention mechanism 1143, the orbiting scroll 1142 will rotate by the driving force transmitted by the rotational shaft 1160 and the like. When the rotating scroll 1142 rotates, fluid cannot be compressed, and the rotating scroll 1142 must perform an orbiting motion relative to the fixed scroll 1141 to compress the fluid.

The rotation prevention mechanism 1143 may be formed of a plurality of pins and rings.

Each ring 1143b is inserted into each of the rotation prevention mechanism seating groove 1142d of the orbiting scroll 1142. Both open sides of the ring 1143b are disposed to face the front and the rear of the motor-operated compressor 1000, respectively. The direction toward the front and the rear of the motor-operated compressor 1000 refers to the axial direction of the rotational shaft 1160.

The pin 1143a is disposed to face the front and the rear of the motor-operated compressor 1000. Each pin 1143a is inserted into a pin accommodating groove 1150e of the main frame 1150 one by one. The pin accommodating groove 1150e may be formed at a position facing the rotation prevention mechanism seating groove 1142d of the orbiting scroll 1142. When an end inserted into the pin accommodating groove 1150e is referred to as a front end of the pin 1143a, a rear end of the pin 1143a is inserted into an area surrounded by the ring 1143b.

When the driving force is transmitted to the orbiting scroll 1142 through the rotational shaft 1160, the orbiting scroll 1142 is moved within an area defined by the rotation prevention mechanism 1143. Accordingly, rotation of the orbiting scroll 1142 is prevented, and the orbiting scroll 1142 can perform an orbiting motion.

The rotation prevention mechanism 1143 is not necessarily configured of pins and rings, but may be configured of various mechanisms such as an Oldham ring.

Next, the main frame 1150 will be described.

The main frame 1150 is configured to support the orbiting scroll 1142 to perform an orbiting motion in the axial direction of the rotational shaft 1160. The main frame 1150 is disposed on an opposite side of the fixed scroll 1141 with respect to the orbiting scroll 1142 to form the back-pressure chamber S4 together with the orbiting scroll 1142.

The inner circumferential surface of the main housing 1110 includes a stepped portion 1114. The main frame 1150 is seated on the stepped portion 1114. When a rear inner diameter and a front inner diameter of the step portion 1114 are compared with each other, the rear inner diameter is greater than the front inner diameter. Accordingly, the main frame 1150 may be seated on the stepped portion 1114.

The main frame 1150 includes a rotational shaft accommodating portion 1150a, a ball bearing mounting portion 1150b, a back-pressure chamber side wall portion 1150c, the thrust surface 1150d, a pin accommodating groove 1150e, and the oil guiding passage 1150f.

The rotational shaft accommodating portion 1150a surrounds the rotational shaft 1160. An inner circumferential surface of the rotational shaft accommodating portion 1150a is brought into contact with the outer circumferential surface of the rotational shaft 1160 and forms a bearing surface and the outer circumferential surface of the rotational shaft 1160. The rotational shaft accommodating portion 1150a supports the rotational shaft 1160 in the radial direction of the rotational shaft 1160.

The ball bearing mounting portion 1150b forms a step in the axial direction with the rotational shaft accommodating portion 1150a. When compared in the axial direction of the rotational shaft 1160, the ball bearing mounting portion 1150b is disposed at a rear side of the rotational shaft 1160 relative to the rotational shaft accommodating portion 1150a. The ball bearing mounting portion 1150b may surround the rotational shaft 1160 at a position spaced apart from the rotational shaft 1160. The ball bearing mounting portion 1150b extends in the radial direction of the rotation shaft 1160 to support the ball bearing 1163 in the axial direction of the rotation shaft 1160, and extends in the axial direction of the rotation shaft 1160 to support the ball bearing 1163 in the radial direction of the rotation shaft 1160.

The back-pressure chamber side wall portion 1150c may surround the rotation shaft 1160 at a position spaced apart from the rotation shaft 1160. The back-pressure chamber side wall portion 1150c extends along the axial direction of the rotation shaft 1160 to form a side wall of the back-pressure chamber S4 in the radial direction of the rotation shaft 1160. When compared in the axial direction of the rotational shaft 1160, the back-pressure chamber side wall portion 1150c is disposed on the rear side of the rotational shaft 1160 relative to the ball bearing mounting portion 1150b.

According to a desired size of the back-pressure chamber S4, the back-pressure chamber side wall portion 1150c may have a differential step with the ball bearing mounting portion 1150b. In this case, a spaced distance in a radial direction from the rotation shaft 1160 is greater in the back-pressure chamber side wall portion 1150c than in the ball bearing mounting portion 1150b.

The thrust surface 1150d faces the orbiting scroll 1142. The thrust surface 1150d is brought into contact with the orbiting end plate portion 1142a of the orbiting scroll 1142. The thrust surface 1150d supports the orbiting scroll 1142 in the axial direction. The orbiting scroll 1142 may be defined in an annular shape.

The pin accommodating groove 1150e is formed in the thrust surface 1150d. A plurality of pin accommodating grooves 1150e is formed around a hole of the main frame 1150 through which the rotation shaft 1160 penetrates. The plurality of pin accommodating grooves 1150e is formed at positions spaced apart from each other along a virtual circumference. The pin accommodating groove 1150e accommodates the pin 1143a of the rotation prevention mechanism 1143.

An inlet of the oil guiding passage 1150f is formed at a position facing the oil guiding passage 1141f of the fixed scroll 1141. And an outlet of the oil guiding passage 1150f is exposed through the back-pressure chamber side wall portion 1150c. Therefore, the oil supplied to the oil guiding passage 1150f of the main frame 1150 through the oil guiding passage 1141f of the fixed scroll 1141 passes through the oil guiding passage 1150f of the main frame 1150 to be supplied to the back-pressure chamber S4.

Next, the rotational shaft 1160 will be described.

The rotational shaft 1160 extends from the front side to the rear side of the motor-operated compressor 1000. A direction in which the rotational shaft 1160 is extending is the axial direction of the rotational shaft 1160.

A front end (first end) of the rotational shaft 1160 penetrates through the rotor 1132 and is supported by the rotational shaft supporting portion 1222. The rotational shaft 1160 is inserted into and fixed to the rotor 1132 in a manner of press-fitting (hot pressing).

A rear end (second end) of the rotation shaft 1160 is coupled to the balance weight 1161. Accordingly, the rotational shaft 1160 rotates together with the rotor 1132 to transmit a rotational force generated by the driving motor to the balance weight 1161.

A portion between the front end and the rear end of the rotational shaft 1160 penetrates through the main frame 1150. The rotational shaft 1160 is supported by the rotor 1132 in the axial direction. The rotational shaft 1160 is supported at two points by the ball bearings 1163, 1164 in the radial direction.

A sealing member 1184, a first separation preventing member 1185, a first ball bearing 1163, a second separation preventing member 1186, and a second ball bearing 1164 may be coupled to the outer circumferential surface of the rotational shaft 1160. The sealing member 1184 is to seal the motor chamber S1 and the back-pressure chamber S4 with each other. The sealing member 1184 may be defined in an annular shape having an O-ring or C-shaped cross section surrounding the rotational shaft 1160. The sealing member 1184 is supported by the main frame 1150 and the first separation preventing member 1185 in the axial direction.

The first separation preventing member 1185 is disposed at a rear side of the sealing member 1184. The first separation preventing member 1185 prevents the sealing member 1184 from being separated in the axial direction toward the rear end of the rotational shaft 1160. In order to prevent separation of the sealing member 1184, the first separation preventing member 1185 is in close contact with the sealing member 1184 in the axial direction. The first separation preventing member 1185 may be formed as a C-shaped plate surrounding the rotational shaft 1160. A groove may be formed in the inner circumferential surface of the main frame 1150 to accommodate an outer edge of the first separation preventing member 1185.

The first ball bearing 1163 surrounds the rear end of the rotational shaft 1160 or a portion close to the rear end of the rotational shaft 1160. The first ball bearing 1163 supports the rotational shaft 1160 in the radial direction. The first ball bearing 1163 is seated on the ball bearing mounting portion 1150b of the main frame 1150. Accordingly, the first ball bearing 1163 is supported by the main frame 1150 in the axial direction and the radial direction of the rotational shaft 1160.

The second separation preventing member 1186 is disposed at a rear side of the first ball bearing 1163. The second separation preventing member 1186 prevents the first ball bearing 1163 from being separated in the axial direction toward the rear end of the rotational shaft 1160. The second separation preventing member 1186 is in close contact with the first ball bearing 1163 in the axial direction to prevent separation of the first ball bearing 1163. The second separation preventing member 1186 may be formed as a C-shaped plate surrounding the rotational shaft 1160. A groove may be formed in an outer circumferential surface of the rotational shaft 1160 to accommodate an inner edge of the second separation preventing member 1186.

The second ball bearing 1164 surrounds a front end of the rotational shaft 1160 or a portion close to the front end of the rotational shaft 1160. The second ball bearing 1164 supports the rotational shaft 1160 in the radial direction. The second ball bearing 1164 is seated on the rotational shaft supporting portion 1222 of the inverter cover 1220. Accordingly, the second ball bearing 1164 is supported by the rotational shaft supporting portion 1222 in the axial direction and the radial direction of the rotational shaft 1160.

Both ends of the rotational shaft 1160 are supported at two points by the first ball bearing 1163 and the second ball bearing 1164 in the radial direction. Accordingly, a length of the rotational shaft accommodating portion 1150a may be sufficiently short compared with a case where the rotational shaft accommodating portion 1150a of the main frame 1150 supports the rotational shaft 1160 at one point. As a result, an axial direction length of the entire motor-operated compressor 1000 may also be shortened, and additional free space may be secured.

The balance weight 1161 is coupled to the front end of the rotational shaft 1160. The balance weight 1161 is provided to cancel an eccentric load (or eccentric amount) of the rotational shaft 1160. The balance weight 1161 includes an eccentric portion 1161a and a mass portion 1161b.

The eccentric portion 1161a is formed at a position corresponding to the rotational shaft 1160 in the axial direction so as to be coupled to the rotational shaft 1160 in the axial direction. The eccentric portion 1161a may be formed in a cylindrical shape like the rotational shaft 1160. However, a diameter of the eccentric portion 1161a is smaller than a diameter of the rotational shaft 1160. The eccentric portion 1161a is coupled to a position eccentric from a position facing a center of the rotational shaft 1160.

The eccentric portion 1161a is coupled to the front end of the rotational shaft 1160 by a connection pin 1162. The connection pin 1162 is disposed to face the axial direction of the rotational shaft 1160 and is inserted into the rotational shaft 1160 and the eccentric portion 1161a. A connection pin accommodating portion 1160a to accommodate the connection pin 1162 is formed at the rotational shaft 1160, and a connection pin accommodating portion (numeral not shown) is also formed at the eccentric portion 1161a.

The connection pin 1162 penetrates at least one of the eccentric portion 1161a and the rotational shaft 1160 at a position eccentric from a center of the rotating shaft 1160 to allow the eccentric portion 1161a to be eccentric from the center of the rotating shaft 1160. For example, the connection pin 1162 is inserted into the rotational shaft 1160 at a position eccentric from the center of the rotational shaft 1160 in FIG. 3.

When the rotational shaft 1160 rotates together with the rotor 1132, the rotational shaft 1160 rotates in place, but the eccentric portion 1161a coupled to the rotational shaft 1160 is eccentrically rotated. The orbiting scroll 1142, which receives the driving force by the eccentric portion 1161a and the ball bearing 1161c, performs an orbiting motion.

The mass portion 1161b extends primarily from an edge of the eccentric portion 1161a toward the radial direction of the rotational shaft 1160, and extends secondly in the axial direction of the rotational shaft 1160. The primary extension of the mass portion 1161b does not face all 360° circumference of the eccentric portion 1161a, but extends in a fan shape having a specific central angle. The secondary extension of the mass portion 1161b extends in a shape of an arc corresponding to the central angle. The secondly extended portion may surround the rotational shaft 1160 by a range corresponding to the central angle.

The ball bearing 1161c is coupled to an outer circumferential surface of the eccentric portion 1161a. And the driving force transmission unit 1142c of the orbiting scroll 1142 is coupled to an outer circumferential surface of the ball bearing 1161c. Accordingly, the orbiting scroll 1142 is disposed at a position eccentric from the center of the rotational shaft 1160 in the axial direction.

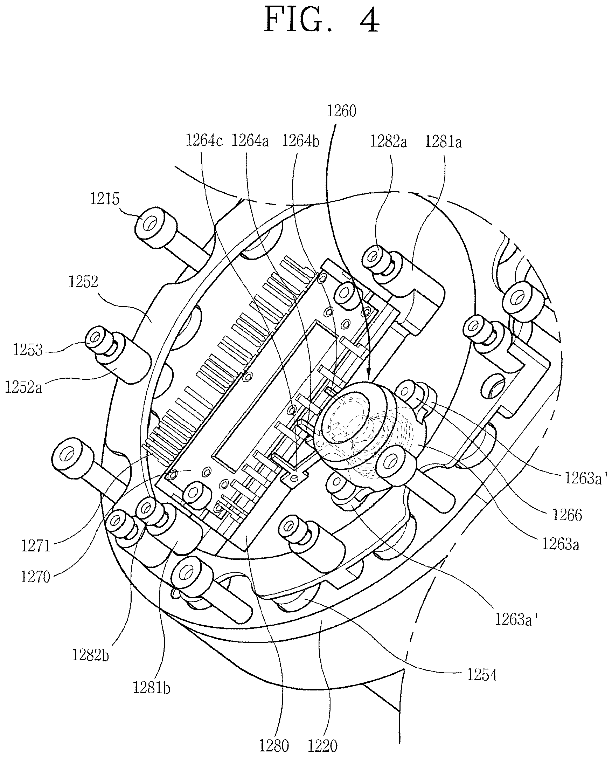

Next, an internal structure of the inverter module 1200 will be described. The internal structure of the inverter module 1200 will be described with reference to FIGS. 3 and 4.

The inverter module 1200 may include the inverter housing 1210, the inverter cover 1220, a circuit component 1230, connectors 1241 and 1242, a printed circuit board 1251, a power element 1270, and a heat sink 1280.

Here, the circuit component 1230 refers to various types of electrical components mounted on the printed circuit board 1251 such as a capacitor and a switching element to perform an electrical function.

The communication connector 1242 is partially inserted into the inverter module 1200 by penetrating through the inverter cover 1220. A portion 1242a of the communication connector 1242 inserted into the inverter module 1200 is electrically connected to the printed circuit board 1251. The communication connector 1242 is fixed to the inverter cover 1220 by the coupling member 1242b. This description is equally applicable to the power connector 1241.

The printed circuit board 1251 is mounted inside the inverter module 1200. A plurality of electrical elements is mounted on the printed circuit board 1251. In particular, the power element 1270 is mounted on the printed circuit board 1251, and the power element 1270 is electrically connected to the driving motor 1130 by the three-phase airtight terminal 1260.

The printed circuit board 1251 is fixed by an annular printed circuit board supporting portion 1252 and a coupling member 1253. In order to maintain functions of the circuit components 1230 mounted on the printed circuit board 1251, the printed circuit board 1251 must be fixed at one position in the inverter module 1200. In particular, a distance between the printed circuit board 1251 and the inverter cover 1220 should be kept constant.

For example, the heat sink 1280 is disposed between the power element 1270 and the inverter cover 1220 to be described later to cool the power element 1270. In case the distance between the printed circuit board 1251 and the inverter cover 1220 is changed, heat conduction function of the heat sink 1280 is severely deteriorated. The printed circuit board supporting portion 1252 not only supports the printed circuit board 1251 by fixing the printed circuit board 1251 at one position, but also maintains a constant distance from the inverter cover 1220.

A plurality of bushes 1252a protrudes toward the inverter cover 1220 around the printed circuit board supporting portion 1252 corresponding to an outer portion of a ring. The plurality of bushes 1252a may be alternately arranged with the coupling member 1215 to couple the inverter cover 1220 and the main housing 1110.

One surface of the printed circuit board 1251 is in close contact with the bushes 1252a, and the coupling member 1253 is coupled to the bushes 1252a at another surface of the printed circuit board 1251. In addition, a plurality of elastic members 1254 is disposed at positions spaced apart from each other between the printed circuit board supporting portion 1252 and the inverter cover 1220 to elastically support the printed circuit board supporting portion 1252. Accordingly, a position of the printed circuit board supporting portion 1252 is fixed, and a position of the printed circuit board 1251 is also fixed by the printed circuit board supporting portion 1252 and the coupling member 1253.

Since the printed circuit board supporting portion 1252 is defined in an annular shape, circuit components 1230 including the power element 1270 may be mounted on the printed circuit board 1251 in and out of the ring.

The three-phase airtight terminal 1260 electrically connects the power element 1270 and the driving motor 1130. Hereinafter, the power element 1270 and the heat sink 1280 will be described first, and then the three-phase airtight terminal 1260 will be described.

The power element 1270 provided in the inverter module 1200 not only provides power to the driving motor 1130 but also controls an operation of the driving motor 1130. The power element 1270 is provided with conductive pins 1271, and the conductive pins 1271 are electrically connected to the printed circuit board 1251 and the three-phase airtight terminal 1260.

The heat sink 1280 is formed of a thermally conductive material, and is disposed between the power element 1270 and the inverter cover 1220. Since one surface of the inverter cover 1220 is exposed to a fluid to be compressed, when the heat sink 1280 is disposed between another surface of the inverter cover 1220 and the power element 1270, it may conduct heat generated in the power element 1270 to the inverter cover 1220 to cool the power element 1270.

Both sides of the heat sink 1280 are provided with bushes 1281a to be coupled with the inverter cover 1220. When the coupling member 1282a is inserted into the bushes 1281a and coupled to the inverter cover 1220, the heat sink 1280 is also coupled to the inverter cover 1220.

The printed circuit board 1251, various circuit components 1230 mounted on the printed circuit board 1251, and the three-phase airtight terminal 1260 which will be described later occupy most of a space formed by the inverter housing 1210 and the inverter cover 1220. Therefore, a volume of the inverter module 1200 is determined according to a volume of the printed circuit board 1251, various circuit components 1230, and the three-phase airtight terminal 1260. In the present disclosure, in particular, a configuration that may reduce the volume of the inverter module 1200 by simplifying a structure of the three-phase airtight terminal 1260 to reduce the volume thereof is provided.

Hereinafter, a configuration capable of reducing the volume of the inverter module 1200 will be described with reference to FIGS. 4 to 7.

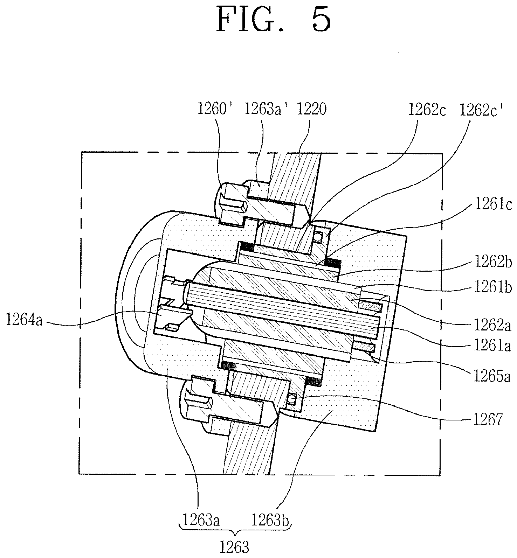

First, FIG. 5 is a sectional view of the three-phase airtight terminal 1260.

The three-phase airtight terminal 1260 is a configuration to electrically connect the power element 1270 and the driving motor 1130. Since the power element 1270 is provided in the inverter module 1200 and the driving motor 1130 is provided in the compression module 1100, the three-phase airtight terminal 1260 should be connected to the power element 1270 and the driving motor 1130 beyond a boundary between the inverter module 1200 and the compression module 1100. In particular, since the three-phase airtight terminal 1260 is exposed to the motor chamber S1 of the compression module 1100, and a refrigerant to be compressed exists in the motor chamber S1, the three-phase airtight terminal 1260 should be able to maintain airtightness.

For example, the boundary between the compression module 1100 and the inverter module 1200 may be formed by the inverter housing 1210 or the inverter cover 1220. In this case, the three-phase airtight terminal 1260 should penetrate through the inverter housing 1210 or the inverter cover 1220 for electrical connection between the power element 1270 and the driving motor 1130. In addition, the three-phase airtight terminal 1260 should be physically coupled to the inverter housing 1210 or the inverter cover 1220 to be fixed by itself.

In the present disclosure, the three-phase airtight terminal 1260 has columnar conductors 1261a, 1261b, 1261c and columnar insulators 1262a, 1262b, 1262c, disposed in an alternating manner along concentric circles. The columnar shape refers to a cylinder shape or a polygonal pillar shape. In order to be disposed in an alternating manner along concentric circles, each of outer diameters of the conductors 1261a, 1261b, 1261c and the insulators 1262a, 1262b, 1262c must be different.

For example, a first conductor 1261a is disposed at a center of the concentric circle and has a shape of a cylinder or a polygonal pillar. A first insulator 1262a has a shape of a hollow cylinder or a hollow polygonal pillar, and surrounds the first conductor 1261a. It may be understood that the first insulator 1262a has a shape corresponding to a larger concentric circle than the first conductor 1261a in a planar view. The first insulator 1262a electrically insulates the first conductor 1261a and a second conductor 1261b.

The second conductor 1261b has a shape of a hollow cylinder or a hollow polygonal pillar and surrounds the first insulator 1262a. It may be understood that the second conductor 1261b has a shape corresponding to a larger concentric circle than the first insulator 1262a in a planar view.

A second insulator 1262b has a shape of a hollow cylinder or a hollow polygonal pillar and surrounds the second conductor 1261b. It may be understood that the second insulator 1262b has a shape corresponding to a larger concentric circle than the second conductor 1261b in a planar view. The second insulator 1262b electrically insulates the second conductor 1261b and a third conductor 1261c.

The third conductor 1261c has a shape of a hollow cylinder or a hollow polygonal pillar and surrounds the second insulator 1262b. It may be understood that the third conductor 1261c has a shape corresponding to a larger concentric circle than the second insulator 1262b in a planar view.

A third insulator 1262c has a shape of a hollow cylinder or a hollow polygonal pillar and surrounds the third conductor 1261c. It may be understood that the third insulator 1262c has a shape corresponding to a larger concentric circle than the third conductor 1261c in a planar view. The third insulator 1262c electrically insulates the third conductor 1261c and the inverter cover 1220.

As such, when the plurality of conductors 1261a, 1261b, 1261c and the plurality of insulators 1262a, 1262b, 1262c are repeatedly and alternately disposed along concentric circles, the plurality of conductors 1261a, 1261b, 1261c can be electrically insulated with each other. The plurality of conductors 1261a, 1261b, 1261c may be connected one by one to the plurality of conductive pins 1271 of the power element 1270, and the plurality of conductors 1261a, 1261b, 1261c may be connected to a plurality of coils (not shown) of the driving motor 1130 one by one.

Since the driving motor 1130 of the compression module 1100 is a three-phase motor operated by three-phase power of U-phase, V-phase, and W-phase, the driving motor 1130 should be electrically connected to the conductive pins 1271 of the power element 1270 one by one. Unlike the related art three-phase terminal being provided with conductors disposed in parallel and thereby occupying a large volume, when the conductors 1261a, 1261b, 1261c are disposed along concentric circles as in the present disclosure, the power element 1270 and the driving motor 1130 may be electrically connected one by one while the conductors occupy relatively small volume.

Furthermore, unlike the related art three-phase terminal separating and insulating the conductors 1261a, 1261b, 1261c disposed in parallel from one another, the insulators 1262a, 1262b, 1262c are disposed between each of the conductors 1261a, 1261b, 1261c in the present disclosure, which may result in enhancing reliability of electrical insulation between each of the conductors 1261a, 1261b, 1261c.

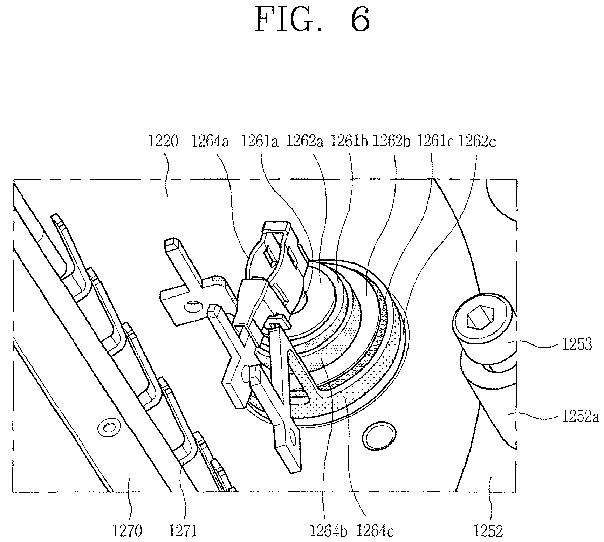

Hereinafter, an electrical connection structure between the three-phase airtight terminal 1260 and the power element 1270, and an insulating structure between each of the conductors 1261a, 1261b, 1261c will be described with reference to FIG. 6. FIG. 6 is a partial perspective view illustrating an internal structure and a periphery of the three-phase airtight terminal exposed when a housing 1263 of the three-phase airtight terminal 1260 of FIG. 6 is separated.

A shape of the conductors 1261a, 1261b, 1261c or the insulators 1262a, 1262b, 1262c is defined as a shape of a cylinder or a polygonal pillar. When comparing lengths of each of the conductors 1261a, 1261b, 1261c based on the height direction in the shape of the cylinder or the polygonal pillar, a length of the first insulator 1262a disposed at the center of the concentric circle is the longest. A length of the second conductor 1261b disposed between the first insulator 1262a and the second insulator 1262b is shorter than the first conductor 1261a and longer than the third conductor 1261c. A length of the third conductor 1261c disposed between the second insulator 1262b and the third insulator 1262c is shorter than the second conductor 1261b.

In addition, when comparing lengths of each of the conductors 1261a, 1261b, 1261c and the insulators 1262a, 1262b, 1262c based on the height direction in the shape of the cylinder or the polygonal pillar, a length of the first insulator 1262a is shorter than the first conductor 1261a and longer than the second conductor 1261b. A length of the second insulator 1262b is shorter than the second conductor 1261b and longer than the third conductor 1261c. A length of the third insulator 1262c is shorter than the third conductor 1261c.

The lengths of the respective conductors 1261a, 1261b, 1261c and the respective insulators 1262a, 1262b, 1262c make both ends of the first conductor 1261a more protrude than the first insulator 1262a in the height direction in the shape of the cylinder or the polygonal pillar. Both ends of the second conductor 1261b are exposed between the first insulator 1262a and the second insulator 1262b in the height direction in the shape of the cylinder or the polygonal pillar. Both ends of the third conductor 1261c are exposed between the second insulator 1262b and the third insulator 1262c in the height direction in the shape of the cylinder or the polygonal pillar.

Busbars 1264a, 1264b, 1264c are provided in the inverter module 1200. The busbars 1264a, 1264b, 1264c electrically connect the conductors 1261a, 1261b, 1261c of the three-phase airtight terminal 1260 and the power element 1270. For example, the busbars 1264a, 1264b, 1264c surround outer circumferential surfaces of the conductors 1261a, 1261b, 1261c. The busbars 1264a, 1264b, 1264c are physically and electrically connected to the conductors 1261a, 1261b, 1261c one by one.

A first busbar 1264a may surround an outer circumferential surface of the first conductor 1261a and be press-fitted to the outer circumferential surface of the first conductor 1261a. A second busbar 1264b may surround an outer circumferential surface of the second conductor 1261b and be press-fitted to the outer circumferential surface of the second conductor 1261b. A third busbar 1264c may surround an outer circumferential surface of the third conductor 1261c and be press-fitted to the outer circumferential surface of the third conductor 1261c.

In particular, the busbars 1264a, 1264b, 1264c connect the conductors 1261a, 1261b, 1261c of the three-phase airtight terminal 1260 and the conductive pins 1271 of the power element 1270 one by one. The first busbar 1264a, the second busbar 1264b, and the third busbar 1264c are coupled to the first conductor 1261a, the second conductor 1261b, and the third conductor 1261c at different positions, respectively, based on the height direction of the cylinder or the polygonal pillar defining the shapes of the conductors 1261a, 1261b, 1261c and the insulators 1262a, 1262b, 1262c. In case a position where the first conductor 1261a and the first busbar 1264a are coupled is the same as the conductive pins 1271 of the power element 1270 in the height direction of the cylinder or the polygonal pillar, the first busbar 1264a may extend in the radial direction of the cylinder or the polygonal pillar to be connected to the conductive pins 1271.

On the other hand, since the second busbar 1264b and the third busbar 1264c are coupled to the second conductor 1261b and the third conductor 1261c, respectively, at positions different from the conductive pins 1271 of the power element 1270 in the height direction of the cylinder or the polygonal pillar, the second busbar 1264b and the third busbar 1264c cannot be connected to the conductive pins 1271 only by extending in the radial direction. Accordingly, the second busbar 1264b and the third busbar 1264c should be primarily extended to a position corresponding to the conductive pins 1271 along the height direction of the cylinder or the polygonal pillar, and secondly extended toward the conductive pins 1271 in the radial direction.

The first busbar 1264a, the second busbar 1264b, and the third busbar 1264c may be directly connected or may be connected by a separate electrical connection member to the conductive pins 1271 of the power element 1270. Each of the first busbar 1264a, the second busbar 1264b, and the third busbar 1264c should be connected to respective conductive pins 1271c for one-on-one connection between the conductors 1261a, 1261b, 1261c and the conductive pins 1271c. To this end, the first busbar 1264a, the second busbar 1264b, and the third busbar 1264c extend in different directions in the radial direction of the cylinder or the polygonal pillar.

Referring again to FIGS. 4 and 5, the motor-operated compressor 1000 includes an airtight terminal housing 1263. The airtight terminal housing 1263 surrounds the three-phase airtight terminal 1260. The airtight terminal housing 1263 includes a first housing 1263a and a second housing 1263b. The first housing 1263a is provided in the inverter module 1200, and the second housing 1263b is provided in the compression module 1100.

The first housing 1263a covers the conductors 1261a, 1261b, 1261c and the insulators 1262a, 1262b, 1262c of the three-phase airtight terminal 1260. The first housing 1263a is coupled to the three-phase airtight terminal 1260 at one side of the three-phase airtight terminal 1260 based on the height direction of the cylinder or the polygonal pillar defining the shape of the conductors 1261a, 1261b, 1261c or the insulators 1262a, 1262b, 1262c. The first housing 1263a is disposed to be spaced apart from the end of the first insulator 1262a in the height direction of the cylinder or the polygonal pillar, and the busbar 1264a is disposed between the first housing 1263a and the end of the first insulator 1262a.

The first housing 1263a has at least one hole in the radial direction for the busbars 1264a, 1264b, 1264c to be penetrated therethrough. The first busbar 1264a, the second busbar 1264b, and the third busbar 1264c are connected to the conductive pins 1271 of the power element 1270 through the hole in the radial direction.

The first housing 1263a has coupling member coupling portions 1263a' protruding from both sides of the first housing 1263a in the radial direction of the cylinder or the polygonal pillar. The coupling member coupling portion 1263a' is provided with a hole in the height direction for penetration of the coupling member 1266. When the first housing 1263a is in close contact with the inverter housing 1210 or the inverter cover 1220, the coupling member coupling portion 1263a' is also in close contact with the inverter housing 1210 or the inverter cover 1220.

When the coupling member 1266 is coupled to the inverter housing 1210 or the inverter cover 1220 by penetrating through the hole in the height direction of the coupling member coupling portion 1263a', the first housing 1263a having the coupling member coupling portion 1263a' is fixed to the inverter housing 1210 or the inverter cover 1220.

Next, an electrical connection structure of the three-phase airtight terminal 1260 and the driving motor 1130 and the insulating structure between each of the conductors 1261a, 1261b, 1261c will be described with reference to FIGS. 5, 7, and 8.

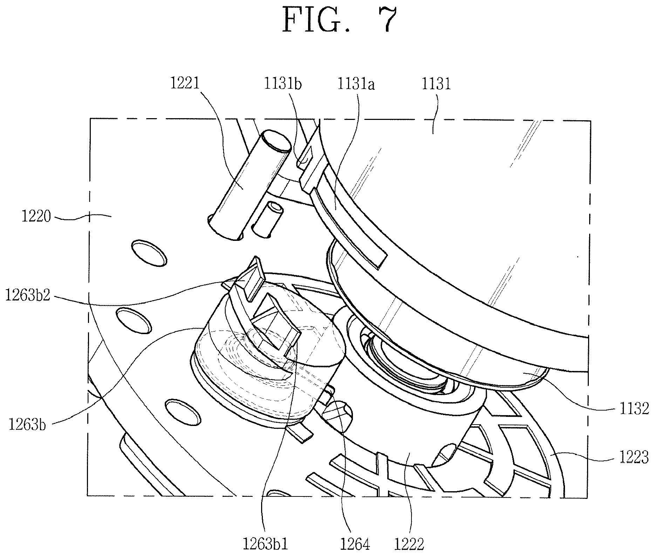

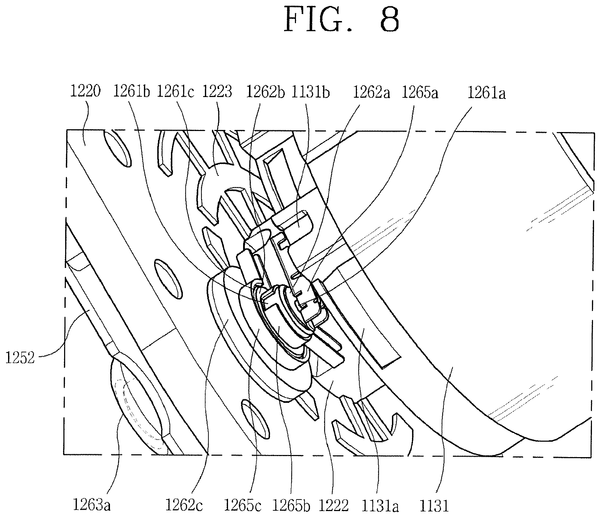

FIG. 7 is a partial perspective view illustrating another side and a periphery of the three-phase airtight terminal 1260 exposed when the main housing 1110 is separated from the inverter cover 1220. FIG. 8 is a partial perspective view illustrating the internal structure and the periphery of the three-phase airtight terminal exposed when the housing 1263 of the three-phase airtight terminal 1260 of FIG. 7 are separated.

Connecting clips 1265a, 1265b, 1265c are provided in the compression module 1100. The connecting clips 1265a, 1265b, 1265c electrically connects the conductors 1261a, 1261b, 1261c of the three-phase airtight terminal 1260 and the driving motor 1130. For example, the connecting clips 1265a, 1265b, 1265c surround the outer circumferential surface of the conductors 1261a, 1261b, 1261c. The connecting clips 1265a, 1265b, 1265c are physically and electrically connected to the conductors 1261a, 1261b, 1261c, one by one. The busbars 1264a, 1264b, 1264c and the connecting clips 1265a, 1265b, 1265c are disposed opposite each other in the height direction of the cylinder or the polygonal pillar defining the shapes of the conductors 1261a, 1261b, 1261c and the insulators 1262a, 1262b, 1262c.

A first connecting clip 1265a may surround the outer circumferential surface of the first conductor 1261a and be press-fitted to the outer circumferential surface of the first conductor 1261a. A second connecting clip 1265b may surround the outer circumferential surface of the second conductor 1261b and be press-fitted to the outer circumferential surface of the second conductor 1261b. A third connecting clip 1265c may surround the outer circumferential surface of the third conductor 1261c and be press-fitted to the outer circumferential surface of the third conductor 1261c.

In particular, the connecting clips 1265a, 1265b, 1265c connect the conductors 1261a, 1261b, 1261c of the three-phase airtight terminal 1260 and the coils (not shown) of the driving motor 1130, one by one. The first connecting clip 1265a, the second connecting clip 1265b, and the third connecting clip 1265c are coupled to the first conductor 1261a, the second conductor 1261b, and the third conductor 1261c at different positions, respectively, based on the height direction of the cylinder or the polygonal pillar defining the shapes of the conductors 1261a, 1261b, 1261c and the insulators 1262a, 1262b, 1262c.

On the other hand, the first connecting clip 1265a, the second connecting clip 1265b, and the third connecting clip 1265c may extend in the radial direction of the cylinder or the polygonal pillar and be connected to the coils (not shown) of the driving motor 1130.

The first connecting clip 1265a, the second connecting clip 1265b, and the third connecting clip 1265c may be directly connected or connected by separate electrical connection members (not shown) to the coils (not shown) of the driving motor 1130. Each of the first connecting clip 1265a, the second connecting clip 1265b, and the third connecting clip 1265c should be connected to respective coils (not shown) for one-on-one connection between the conductors 1261a, 1261b, 1261c and the coils (not shown). To this end, the first connecting clip 1265a, the second connecting clip 1265b, and the third connecting clip 1265c extend in different directions in the radial direction of the cylinder or the polygonal pillar.

Referring again to FIG. 5, the insulator disposed at an outermost of the insulators 1262a, 1262b, 1262c of the three-phase airtight terminal 1260 includes an inverter coupling portion 1262c' protruding in an annular shape in the radial direction. Since the insulator disposed at the outermost of the insulators 1262a, 1262b, 1262c of the three-phase airtight terminal 1260 is the third insulator 1262c, the inverter coupling portion 1262c' is provided in the third insulator 1262c.

The inverter coupling portion 1262c' is in close contact with one surface of the inverter housing 1210 or one surface of the inverter cover 1220 along a circumferential direction. The second housing 1263b makes the inverter coupling portion 1262c' to be in close contact with the inverter housing 1210 or the inverter cover 1220.

Since the three-phase airtight terminal 1260 is exposed to the motor chamber S1 and a refrigerant to be compressed exists in the motor chamber S1, introduction of the refrigerant from the motor chamber S1 into the three-phase airtight terminal 1260 and from the compression module 1100 to the inverter module 1200 should be prevented. To this end, the sealing member 1267 is disposed between the inverter coupling portion 1262c' and one surface of the inverter housing 1210 or between the inverter coupling portion 1262c' and one surface of the inverter cover 1220. The inverter coupling portion 1262c' may have an annular groove to accommodate the sealing member 1267, and the annular sealing member 1267 may be seated in the groove.

Referring again to FIGS. 5 and 8, the second housing 1263b provided inside the compression module 1100 covers the conductors 1261a, 1261b, 1261c and the insulators 1262a, 1262b, 1262c of the three-phase airtight terminal 1260. The second housing 1263b is coupled to the three-phase airtight terminal 1260 at another side of the three-phase airtight terminal 1260 based on the height direction of the cylinder or the polygonal pillar defining the shape of the conductors 1261a, 1261b, 1261c or the insulators 1262a, 1262b, 1262c. The second housing 1263b is disposed to be spaced apart from the end of the first insulator 1262a in the height direction of the cylinder or the polygonal pillar, and the first connecting clip 1265a is disposed between the second housing 1263b and the end of the first insulator 1262a.

The second housing 1263b has at least one hole in the radial direction for the connecting clips 1265a, 1265b, 1265c to be penetrated therethrough. The first connecting clip 1265a, the second connecting clip 1265b, and the third connecting clip 1265c are connected to the coil (not shown) of the driving motor 1130 through the hole in the radial direction.

Unlike the first housing 1263a being coupled to the inverter housing 1210 or the inverter cover 1220, the second housing 1263b is fixed by the driving motor 1130. Referring to FIG. 7, the second housing 1263b includes a driving motor coupling portion 1263b1.

The driving motor coupling portion 1263b1 protrudes from the second housing 1263b toward the driving motor 1130. The driving motor 1130 has a groove 1131a to accommodate the driving motor coupling portion 1263b1. A step exists in the driving motor coupling portion 1263b1, and the driving motor coupling portion 1263b1 is partially inserted into the groove 1131a and coupled to the driving motor 1130 in a hook coupling manner.

Since the driving motor 1130 is fixed to the inner circumferential surface of the main housing 1110, when the second housing 1263b is coupled to the driving motor 1130 by the driving motor coupling portion 1263b1, the second housing 1263b is pressed toward the inverter module 1200 by the motor 1130. When the second housing 1263b presses the inverter module 1200 according to the law of action-reaction, the inverter module 1200 also presses the second housing 1263b, so that the second housing 1263b is pressed from both sides by the driving motor 1130 and the inverter module 1200 and be fixed at its position.

Meanwhile, the second housing 1263b is provided with a positioning protrusion 1263b2 protruding toward the driving motor 1130. The positioning protrusion 1263b2 may protrude from the driving motor coupling portion 1263b1. For example, when a hook is provided on a first surface of the driving motor coupling portion 1263b1, the positioning protrusion 1263b2 may be formed on a second surface of the driving motor coupling portion 1263b1.

The driving motor 1130 is provided with a positioning groove 1131b at a position corresponding to the positioning protrusion 1263b2, and when the positioning protrusion 1263b2 is inserted into the positioning groove 1131b, positions of the second housing 1126b and the three-phase airtight terminal 1260 may be set to correct positions.

The motor-operated compressor described above is not limited to the configurations and the methods of the embodiments described above, but the embodiments may be configured by selectively combining all or part of the embodiments so that various modifications or changes can be made.

## Claims

1. A motor-operated compressor (1000) comprising:
a compression module (1100) configured to compress a fluid to be compressed by an orbiting motion of a scroll (1142);
an inverter module (1200) configured to control an operation of the compression module (1100);
a driving motor (1130) provided in the compression module (1100) and configured to provide a rotational force for the orbiting motion of the scroll (1142);
a power element (1270) provided in the inverter module (1200) and configured to provide power to the driving motor (1130); and
a three-phase airtight terminal (1260) electrically connecting the power element (1270) and the driving motor (1130) and having columnar conductors (1261a, 1261b, 1261c) and columnar insulators (1262a, 1262b, 1262c) disposed in an alternating manner along concentric circles.

2. The compressor (1000) of claim 1, wherein the three-phase airtight terminal (1260) comprises:
a first conductor (1261a) in a cylindrical shape disposed in a center of the concentric circles;
a first insulator (1262a) in a hollow cylindrical shape formed to surround the first conductor (1261a);
a second conductor (1261b) in a hollow cylindrical shape formed to surround the first insulator (1262a);
a second insulator (1262b) in a hollow cylindrical shape formed to surround the second conductor (1261b);
a third conductor (1261c) in a hollow cylindrical shape formed to surround the second insulator (1262b); and
a third insulator (1262c) in a hollow cylindrical shape formed to surround the third conductor (1261c),
wherein a length of the second conductor (1261b) in a height direction of the cylindrical shape is shorter than the first conductor (1261a) and longer than the third conductor (1261c).

3. The compressor (1000) of claim 2, wherein a length of the first insulator (1262a) is shorter than the first conductor (1261a) and longer than the second conductor (1261b) in the height direction of the cylindrical shape,
a length of the second insulator (1262b) is shorter than the second conductor (1261b) and longer than the third conductor (1261c) in the height direction of the cylindrical shape, and
a length of the third insulator (1262c) is shorter than the third conductor (1261c) in the height direction of the cylindrical shape.

4. The compressor (1000) of claim 2 or 3, wherein both ends of the first conductor (1261a) protrude more than the first insulator (1262a) based on the height direction of the cylindrical shape,
both ends of the second conductor (1261b) are exposed between the first insulator (1262a) and the second insulator (1262b) based on the height direction of the cylindrical shape, and
both ends of the third conductor (1261c) are exposed between the second insulator (1262b) and the third insulator (1262c) based on the height direction of the cylindrical shape.

5. The compressor (1000) of any one of the preceding claims, further comprising:
a busbar (1264a, 1264b, 1264c) electrically connecting the conductor (1261a, 1261b, 1261c) of the three-phase airtight terminal (1260) and the power element (1270); and
a connecting clip (1265a, 1265b, 1265c) electrically connecting the conductor (1261a, 1261b, 1261c) of the three-phase airtight terminal (1260) and the driving motor (1130),
wherein the busbar (1264a, 1264b, 1264c) and the connecting clip (1265a, 1265b, 1265c) are configured to surround an outer circumferential surface of the conductor (1261a, 1261b, 1261c), respectively.

6. The compressor (1000) of claim 5, wherein the busbar (1264a, 1264b, 1264c) and the connecting clip (1265a, 1265b, 1265c) are press-fitted to the outer circumferential surface of the conductor (1261a, 1261b, 1261c), respectively.

7. The compressor (1000) of any one of the preceding claims, wherein the inverter module (1200) comprises an inverter housing (1210) or an inverter cover (1220) forming a boundary between the compression module (1100) and the inverter module (1200), and
the three-phase airtight terminal (1260) penetrates through the inverter housing (1210) or the inverter cover (1220), and is physically coupled to the inverter housing (1210) or the inverter cover (1220).

8. The compressor (1000) of claim 7, wherein the insulator (1262a, 1262b, 1262c) disposed at outermost of the insulators (1262a, 1262b, 1262c) is provided with an inverter coupling portion (1262c') protruding in an annular shape in a radial direction,
wherein the inverter coupling portion (1262c') is in close contact with one surface of the inverter housing (1210) or one surface of the inverter cover (1220).

9. The compressor (1000) of claim 8, further comprising:
a sealing member (1267) in an annular shape,
wherein the sealing member (1267) is disposed between the inverter coupling portion (1262c') and one surface of the inverter housing (1210) or between the inverter coupling portion (1262c') and one surface of the inverter cover (1220).

10. The compressor (1000) of any one of the preceding claims, further comprising:
an airtight terminal housing (1263) formed to surround the three-phase airtight terminal,
wherein the airtight terminal housing (1263) comprises:
a first housing (1263a) provided in the inverter module (1200) and coupled to one side of the three three-phase airtight terminal (1260) based on a height direction of a cylindrical shape; and
a second housing (1263b) provided in the compression module (1100) and coupled to another side of the three three-phase airtight terminal (1260) based on the height direction of the cylindrical shape.

11. The compressor (1000) of claim 10, wherein the inverter module (1200) comprises an inverter housing (1210) or an inverter cover (1220) forming a boundary between the compression module (1100) and the inverter module (1200),
the first housing (1263a) is provided with a coupling member coupling portion (1263a') protruding in a radial direction from both sides,
wherein the coupling member coupling portion (1263a') is in close contact with the inverter housing (1210) or the inverter cover (1220), and is fixed by a coupling member (1266) penetrated through the coupling member coupling portion (1263a') and coupled to the inverter housing (1210) or the inverter cover (1220).

12. The compressor (1000) of claim 10 or 11, wherein the second housing (1263b) is provided with a driving motor coupling portion (1263b1) physically coupled to the driving motor (1130),
wherein the driving motor coupling portion (1263b1) is coupled to the driving motor (1130) in a hook coupling manner.

13. The compressor (1000) of any one of claims 10 to 12, wherein the second housing (1263b) is provided with a positioning protrusion (1263b2) protruding toward the driving motor (1130),
wherein the positioning protrusion (1263b2) is inserted into a positioning groove (1131b) formed in the driving motor (1130).

14. The compressor (1000) of any one of claims 7 to 13, wherein a heat sink (1280) is disposed between the power element (1270) and the inverter cover (1220), which is preferably formed of a thermally conductive material.

15. The compressor (1000) of claim 14, wherein both sides of the heat sink (1280) are provided with bushes (1281a) to be coupled with the inverter cover (1220).
